# EUROPEAN PATENT APPLICATION

(11) **EP 0 771 012 A2**
(43) Date of publication of application: **02.05.1997**
(21) Application number: 97100874.3
(22) Date of filing: 24.08.1994
(51) Int. Cl.: H01F 27/28

(54) **Printed coil type transformer**

(62) Divisional of application: 94113273.0
(71) Applicant: Yokogawa Electric Corporation, Musashino-shi, Tokyo, 180 (JP)
(72) Inventor: Inoh, Kiyoharu, Mitaka-shi, Tokyo 181 (JP); Takano, Hisanaga, Mitaka-shi, Tokyo 181 (JP)
(74) Representative: Henkel, Feiler, Hänzel & Partner

(57) **Abstract**

A printed coil type transformer having a good magnetic coupling, low loss and good high frequency characteristics as a transformer is provided. The printed coil type transformer includes a primary coil means 10 comprising a conductor pattern equivalent to a primary winding of a transformer, a secondary coil means 20 comprising a conductor pattern equivalent to a secondary winding n2 of the transformer, wherein the primary winding and the secondary winding are connected to independent grounds, and wherein transformer polarity of the primary winding and the secondary winding are opposite, and a third coil means 72 comprising a conductor pattern, one end of which is grounded and whose transformer polarity coincides with that of the secondary winding. The third coil means 72 further comprises a conductor winding layer on which voltage of the conductor pattern on the third coil means 72 generated by an AC voltage applied to the primary winding almost coincides with a voltage generated on the secondary winding.

## Description

### BACKGROUND OF THE INVENTION

### Field of the Invention

The present invention relates to a printed coil type transformer used for electronic devices and power units and more particularly to a device having a favorable magnetic coupling, low loss and high frequency characteristics.

### Description of the Related Art

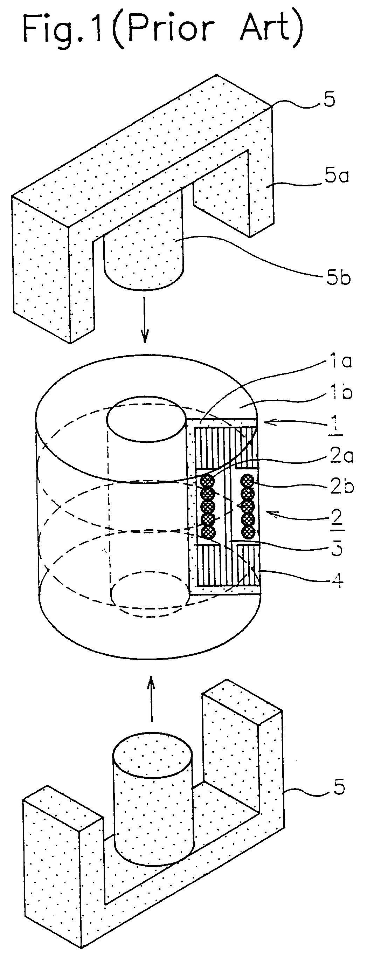

A transformer is a magnetic component used for electronic devices and power units, whose gap between a primary coil and secondary coil is insulated and which has a characteristic that a voltage of the secondary coil is determined corresponding to a voltage of the primary coil and their winding ratio. Fig. 1 is a perspective view of a structure of a prior art transformer using a bobbin, wherein a main part thereof is shown by a partially cutaway view. In the figure, the bobbin 1 is molded by an insulative resin or the like and ring shape collar sections 1b are created at the both ends of a tubular cylindrical section 1a. Winding section 2 is composed of conductive wires wound around the cylindrical section 1a of the bobbin 1, wherein a primary winding 2a and secondary winding 2b form a double layer pinching an insulating tape 3 therebetween. Barriers 4 are provided in the bobbin 1 in order to secure a gap between the winding 2 and the collar section 1b to meet a safety standard and are constructed by winding two layers of tape-shape insulator pinching the insulator tape 3. A core 5 is an EE type core made of a magnetic material and has a middle leg 5b which penetrates through the cylindrical section 1a of the bobbin 1 and leg sections 5a positioned on the both sides of the middle leg 5b. A closed magnetic path is created by combining two of the EE type cores 5 to improve a state of electromagnetic coupling of the transformer.

However, because the wire 2 is wound around the cylindrical bobbin 1 in the conventional transformer, there are problems that winding operation is cumbersome and the device becomes large since the bobbin 1 occupies the most of the volume. Further, the barriers 4 need to be provided because the insulation must be fully maintained in order to meet the safety standard. It is because the surroundings of the winding 2 is not covered by an insulator, a gap necessary for the insulation increases.

Then a device in which the winding operation is simplified has been disclosed in Japanese Utility Model Laid-open No. 4-46524 which the applicant of the present invention had applied. Figs. 2A and 2B are drawings showing a structure of the device disclosed in said publication, wherein Fig. 2A shows its section view and Fig. 2B shows a perspective view of a simplex stack bobbin 6. Several stack bobbins 6 are laminated and a core 5 is attached therein in a transformer. A plate insulating barrier 7 is attached at the boundary between the primary and secondary sides of the stack bobbins 6. Insulating covers 8 are attached on the outsides of the stack bobbins 6.

Explaining the stack bobbin 6 in detail, it has a plate 6a which is a partition between the layers of windings 2 and a cylindrical magnetic core section 6b having a rectangular opening provided at the center of the plate 6a. Two pull out guide sections 6c provided at the both ends of the lower end of the plate 6a keep the plate 6a at a predetermined posture. A pin section 6d is a terminal provided on the pull out guide section 6c which is soldered to a printed board (not shown) and the winding 2 is connected. When the plates 6a are to be stacked, they may be disposed in a telescopic manner so that the pull out guide sections 6c will not interfere each other. The winding 2 is wound centering on the magnetic core section 6b and the both ends thereof are connected to the pin sections 6d. Then the middle leg of the core 5 penetrates through this magnetic core section 6b. By constructing as described above, because the winding operation just needs to be done along the plate 6a centering on the magnetic core section 6b, it may be simplified as compare to the case when the winding 2 is wound around the cylindrical bobbin 1.

However, because the surroundings of the winding 2 is not covered by an insulator, a gap necessary for insulation increases, leaving a problem that the size of the transformer increases. Further, because a number of pin sections 6d increases corresponding to a number of laminations of the stack bobbins 6 when the telescopic structure is adopted for the pull out guide section 6c, there is a such problem that the operation for winding the winding around each pin section 6d or for wiring between each pin section 6d becomes complicated.

Furthermore, because the primary coil and secondary coil are separately laminated on the stack bobbin 6, only the plane on which the insulating barrier 7 is provided becomes the magnetic coupling plane of the primary and secondary windings, thereby increasing a leakage inductance and degrading the magnetic coupling of the primary and secondary windings. Further, for an AC resistance, there is a characteristic that an effective resistance significantly increases by so-called a proximity effect when there is a conductor in which a current flows in the same direction in high frequency. Then there is a problem that a resistance increases if it is assembled so that the winding direction on each plate of the stack bobbin 6 flows current in the same direction.

Further, as for a floating capacity, there is a problem between adjacent plates among the stack bobbin 6. If a commercial power source is now connected to the primary side, a voltage on the primary side is 100 V to 220 V and if the secondary side is used for driving a logic circuit, its voltage is 5 V to 15 V; the primary voltage is higher than the secondary voltage by about one digit. Because electrostatic energy is proportional to a square of voltage, a floating capacity of the stack bobbin 6 used as the primary coil becomes 100 times of that of the secondary coil if the transformation ratio of the transformer is 10:1.

EP-A-0 267 108 discloses a transformer in which a terminal conduit connects windings to terminal bores. The inner terminal of the conductor on a board is located directly above the inner terminal of the conductor on another board. The terminal points are connected to each other by conductive plates on the cylindrical surfaces of the board via bores. Such bores are located on the outer periphery of the winding.

Accordingly, it is a primary object of the present invention to provide a small and low cost device.

A second object of the present invention is to provide a device wherein the operation for connecting each terminal is easy even if a number of laminated coils increases.

A third object of the present invention is to provide a transformer having a favorable magnetic coupling, low loss and high frequency characteristics.

A fourth object of the present invention is to provide a device which generates less noise and has a good shielding characteristic when used for a switching power source.

### SUMMARY OF THE INVENTION

According to the present invention, the above objects are solved by a printed coil type transformer as defined in the claims.

Particularly, in a preferred embodiment the transformer polarity of the conductor patterns on the primary coil and secondary coil are opposite. Then the third coil is inserted as one having a transformer polarity of the secondary coil between the both coils and allocates a region where the voltage of the secondary coil almost coincides with AC voltage. Accordingly, a potential difference of opposed layers becomes small, hampering a flow of noise current and reducing noise, which is preferable for the transformer.

Both ends of each conductor pattern may be connected to the outer and inner peripheral connecting holes and a connection is made from the inner peripheral connecting hole to the outer peripheral connecting hole on the connecting coil by the connection pattern. Then they are connected to a wiring of the printed board via terminals attached to the outer peripheral connecting holes and the through hole. Because the conductor pattern of each plate coil is connected through the inner and outer peripheral connecting holes, a degree of freedom of the disposition of coils improves, allowing to dispose the coils so that the magnetic coupling becomes better, the loss becomes less and the high frequency characteristic becomes better. Further, because a plurality of connection relationships of each conductor pattern may be realized even on the same plate coil by appropriately selecting the connection pattern on the connecting coil, the mass-producibility may be enhanced.

Furthermore, a secondary coil may be pinched by primary coils, so that the magnetic coupling between the primary winding and secondary winding becomes better. Due to that, the leakage inductance reduces, the increase of resistance caused by the proximity effect may be suppressed and the floating capacity can be less.

The above and other advantages of the present invention will become more apparent in the following description and the accompanying drawings in which like numerals refer to like parts.

### BRIEF DESCRIPTION OF THE DRAWINGS

Fig. 1 is a perspective view of a structure of a prior art transformer using a bobbin, wherein a main part thereof is broken;

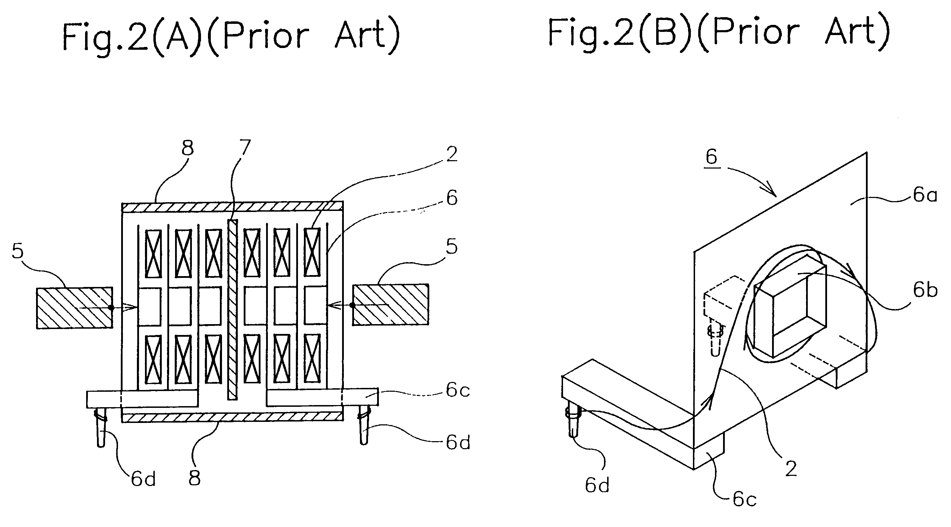

Figs. 2A and 2B are drawings showing a structure of the prior art device, wherein Fig. 2A shows its section view and Fig. 2B shows a perspective view of a part.
Fig. 3 is a perspective view of a coil structure in a state being assembled;
Figs. 4A and 4B show a printed coil laminate 50, wherein Fig. 4A shows its top plan view and Fig. 4B shows its section view;
Fig. 5 is a section view showing a state a printed coil type transformer is packed on a printed board;
Fig. 6 is a circuit diagram when the printed coil type transformer is packaged on a switching power source;
Fig. 7 is a perspective view for explaining a connection state of conductor patterns of the plate coils used for the circuit in Fig. 6;
Fig. 8 is a diagram for explaining a connection pattern 61 of a connecting coil 60;
Figs. 9A and 9B are drawings for explaining distribution of NI in a direction of thickness of the coil laminate 50;
Figs. 10A and 10B are drawings for explaining another connection pattern 61 of the connecting coil 60;
Figs. 11A and 11B are drawings for explaining a wiring state of the connecting coil 60 on the printed coil laminate 50;
Fig. 12 is a drawing for explaining a connection state of the device in Fig. 7;
Fig. 13 is a drawing showing a structure of a prior art device for comparing with the embodiment shown in Fig. 12;
Fig. 14 is a perspective view showing another coil structure;
Figs. 15A and 15B are perspective views showing a coil structure wherein there are two secondary outputs;
Figs. 16A and 16B are perspective views for explaining a case when a plurality of primary coils are provided;
Fig. 17 is a circuit diagram showing a choking coil;
Fig. 18 is a perspective view for explaining a connection state of a choking coil used in Fig. 17;
Fig. 19 is a circuit diagram of a transformer having a shield;
Fig. 20 is a perspective view of a structure of main part of a printed coil type transformer showing a packaged state equivalent to the circuit in Fig. 19;
Fig. 21 is a graph showing a relationship between a number of windings of each winding and AC voltage;
Fig. 22 is a circuit diagram showing a first embodiment of the present invention;
Fig. 23 is a perspective view of a main part of the device in Fig. 22 showing a packaged state thereof;
Fig. 24 is a graph showing a relationship between a number of windings of each winding and AC voltage in Fig. 22;
Fig. 25 is a circuit diagram showing a second embodiment of the present invention;
Fig. 26 is a perspective view of a main part of the device in Fig. 25 showing a packaged state thereof; and
Fig. 27 is a graph showing a relationship between a number of windings of each winding and AC voltage in Fig. 25.

### DETAILED DESCRIPTION OF PREFERRED EMBODIMENT

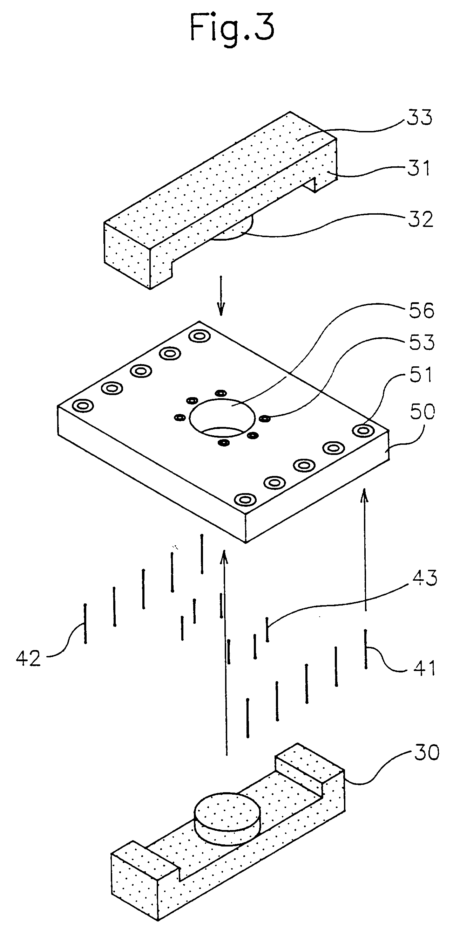

Referring now to the drawings, first of all a printed coil will be explained. Fig. 3 is a perspective view of such a coil structure in a state being assembled. In the figure, a core 30 is a so-called EE shape core and both end cores 31 have a rectangular section and a middle leg core 32 has a circular section. A connecting section 33 is a core material connecting the both end cores 31 and middle leg core 32 and has a rectangular section.

Terminals 40, including primary terminals 41, secondary terminals 42 and inner peripheral terminals 43, are used to connect signal lines on the primary and secondary sides when a transformer is assembled. While at least two each of the primary terminals 41 and 42 are necessary here, the number may be increased corresponding to a number of printed coil laminates 50. Further, a number of the inner peripheral terminals 43 may be determined corresponding to the number of printed coil laminates 50 and to connection type and 6 terminals are provided in this example centering on a core inserting hole 56.

The plate printed coil laminate 50 has a function of the primary and secondary windings of a transformer and forms a magnetic circuit by inserting the middle leg core 32 to the core inserting hole 56 provided at the center thereof and by pinching the outside by the both end cores 31. The connecting section 33 of the core 30 is positioned at the center of the surface of the printed coil laminate 50 and the primary terminal 41 and the secondary terminal 42 are positioned on the both sides thereof.

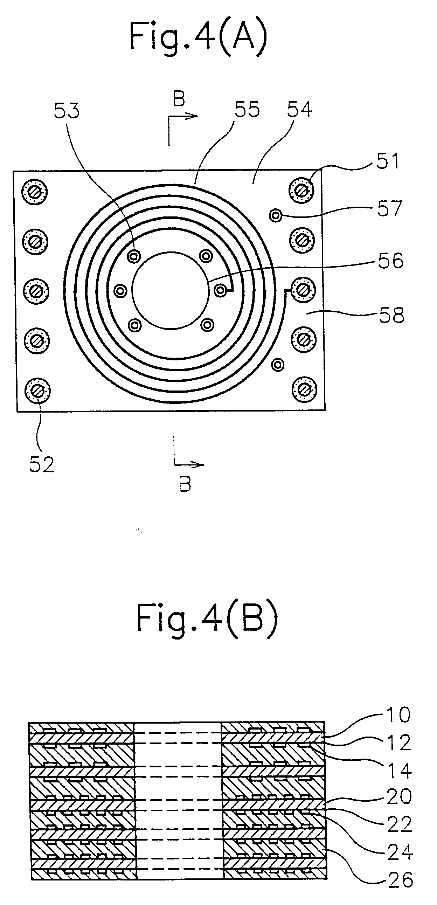

Figs. 4A and 4B show a structure of the printed coil laminate 50, wherein Fig. 4A shows its top plan view and Fig. 4B shows its section view taken along a line B-B. The printed coil laminate 50 is what plate coils 58 are laminated. The core inserting hole 56 is provided at the center and five primary outer peripheral connecting holes 51 and five secondary outer peripheral connecting holes 52 are provided in a row on the both ends on the plate coil 58. Six inner peripheral connecting holes 53 are provided near the core inserting hole 56. Two interlayer connecting holes 57 are provided near the primary outer peripheral connecting hole 51 and are used when the inner peripheral connecting holes 53 are not enough for interlayer connection between each plate coils 58.

After laminating the plate coil 58, the primary terminal 41 is soldered to the primary outer peripheral connecting hole 51,the secondary terminal 42 is soldered to the secondary outer peripheral connecting hole 52 and the inner peripheral terminal 43 is soldered to the inner peripheral connecting hole 53. Here the primary terminal 41, the secondary terminal 42 and the inner peripheral terminal 43 are made from a metallic short rod such as copper which is suitable for soldering. The primary terminal 41 and the secondary terminal 42 has a length which reaches to a printed board 28 and the inner peripheral terminal 43 has a length of the thickness of the printed coil laminate 50. When the interlayer connecting hole 57 is used, the same terminal with the inner peripheral terminal 43 is attached also to it. A conductor forming plane 54 is an area between the core inserting hole 56, the primary outer peripheral connecting hole 51 and the secondary outer peripheral connecting hole 52 and on which a spiral conductor pattern 55 is formed.

The conductor pattern 55 is formed on the both sides or one side of the plate coil 58. In Fig. 4B, the conductor patterns 55 are formed on the both sides. In a case of a primary coil 10 in which the conductor pattern 55 has a function of a primary winding, one end thereof is connected to the primary outer peripheral connecting hole 51 and the other end is connected to the inner peripheral connecting hole 53. In a case of a secondary coil 20 in which the plate coil 58 has a function of a secondary winding, one end thereof is connected to the secondary outer peripheral connecting hole 52 and the other end is connected to the inner peripheral connecting hole 53.

Referring now to Fig. 4B, a laminated state of the plate coils 58 will be explained. In this example, the primary coil 10 is formed on the both sides of a base plate 12 using wiring patterns 14 and the secondary coil 20 is formed on the both sides of a base plate 22 using wiring patterns 24. Then two sheets of the base plate 12 are laminated and below that, three sheets of the base plate 22 are laminated. Insulative resin 26 is filled between each base plates 12 and 22 and thereby the wiring patterns 14 and 24 which have the same functions with the conventional windings are coated by the insulator 26. As a result, the gap necessary for meeting the safety standard can be short.

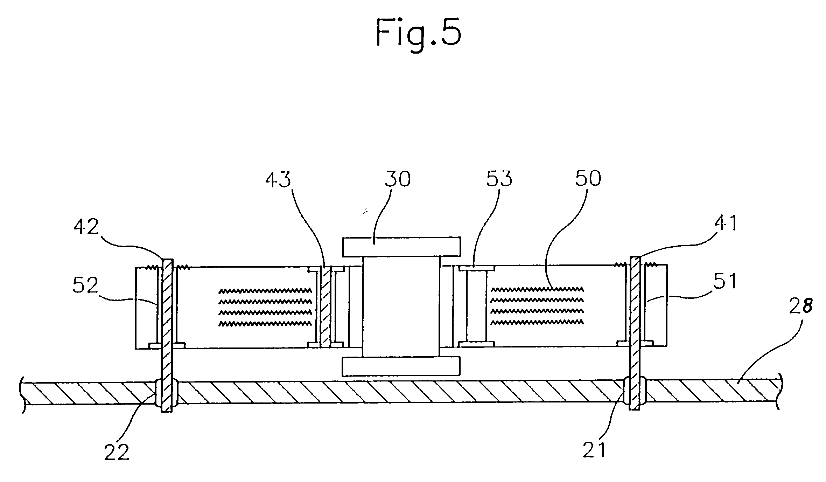

Fig. 5 is a section view showing a state in which a printed coil type transformer is packaged on the printed board. In the figure, a primary through hole 21 and secondary through hole 22 are provided on the printed board 20. When the printed coil laminate 50 is packaged to the printed board 28, the primary terminal 41 and the secondary terminal 42 are soldered to the primary through hole 21 and secondary through hole 22.

Here the primary terminal 41, secondary terminal 42 and inner peripheral terminal 43 need to be disposed so that an insulation distance necessary for meeting the safety standard is maintained by fully assuring a spatial distance to the conductor pattern 55 on the conductor forming plane 54. Here each terminals 41 through 43 are disposed by providing the outer peripheral connecting holes 51 and 52 and inner peripheral connecting holes 53 at the outer and inner peripheral sections of the spiral conductor pattern 55, by implanting the primary terminal 41 into the primary outer peripheral connecting hole 51, implanting the secondary terminal 42 into the secondary outer peripheral connecting hole 52 and implanting the inner peripheral terminal 43 into the inner peripheral connecting hole 53. Thereby an extra spatial distance needs not be assured on the conductor forming plane 54, allowing to maximize the coil area. As a result, a magnetic coupling which is proportional to the coil area may be maximized, bringing about such an effect that the magnetic coupling between the coils becomes better.

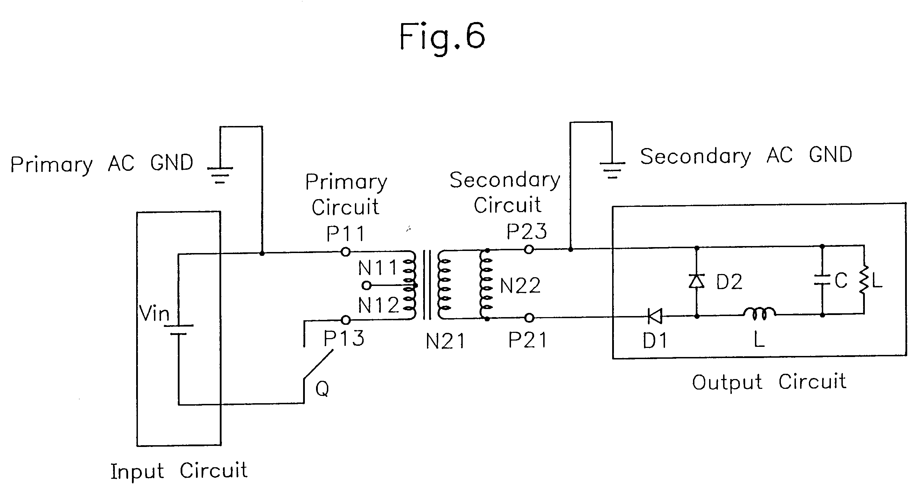

Fig. 6 is a circuit diagram when the printed coil type transformer is packaged on a switching power source. A DC power Vin is applied to the primary winding and is turned ON/OFF by a switching element Q. Then a switching signal is induced on the secondary winding and is sent to an output circuit containing diodes D1 and D2, choking coil L and capacitor C to supply rectified and smoothed DC voltage to a load L. Here in the primary winding, a primary coil N11 and primary coil N12 are connected in series and in the secondary winding, a secondary coil N21 and N22 are connected in parallel. Further, a terminal P11 is connected to the DC power Vin and a terminal P13 is connected to the switching element Q. Terminals P21 and P23 connect the both ends of the secondary coils N21 and N22 with the output circuit.

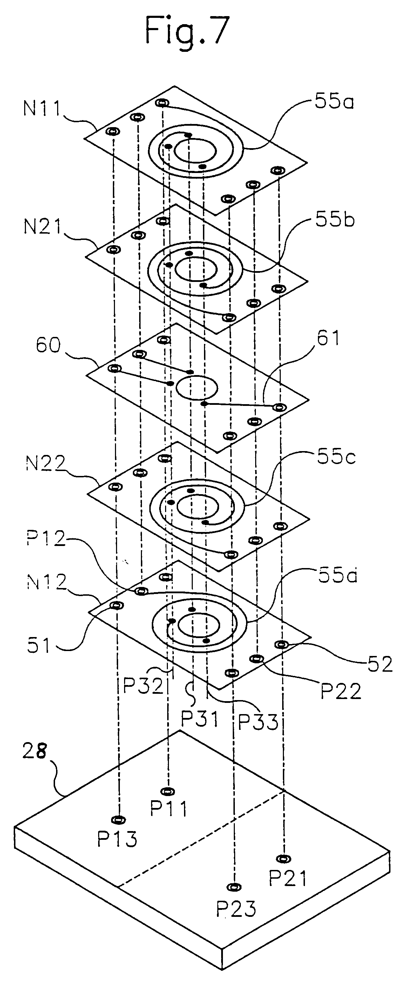

Fig. 7 is a perspective view for explaining a connection state of conductor patterns of the plate coils used for the circuit in Fig. 6. By the way, those plate coils on which the conductor pattern is formed only on the single side thereof are shown here. In the figure, the secondary coils N21 and N22 for secondary winding are pinched by the primary coils N11 and N12 for primary winding and the coil N12 faces to the printed board 28. A connection coil 60 is provided between the secondary coils N21 and N22. The primary coils N11 and N12 have spiral conductor patterns 55a and 55d which turn twice from the primary outer peripheral connecting hole 51 to the inner peripheral connecting hole 53. The conductor pattern 55a is connected to the primary outer peripheral connecting hole 51 which corresponds to the terminal P11 and to the inner peripheral connecting hole 53 which corresponds to the terminal P31, and the conductor pattern 55d is connected to the primary outer peripheral connecting hole 51 which corresponds to the terminal P12 and to the inner peripheral connecting hole 53 which corresponds to the terminal P32.

The secondary coils N21 and N22 have spiral conductor patterns 55b and 55c which turn twice from the secondary outer peripheral connecting hole 52 to the inner peripheral connecting hole 53. The conductor pattern 55b is connected to the secondary outer peripheral connecting hole 52 which corresponds to the terminal P23 and to the inner peripheral connecting hole 53 which corresponds to the terminal P33, and the conductor pattern 55c is connected to the secondary outer peripheral connecting hole 52 which corresponds to the terminal P23 and to the inner peripheral connecting hole 53 which corresponds to the terminal P33. Necessary connections are provided by connection patterns 61 on the connecting coil 60. The terminals P11 and P13 are disposed on the primary circuit side and the terminals P21 and P23 are disposed on the secondary circuit side on the printed board 28.

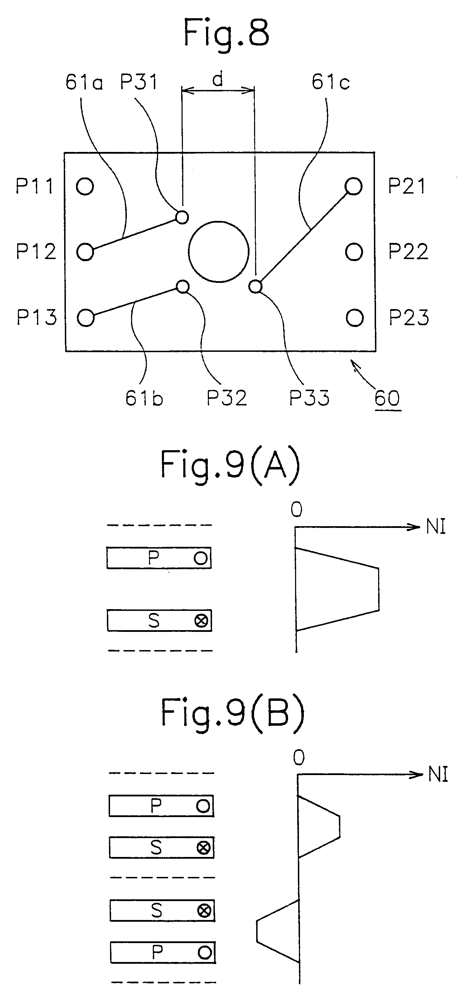

Fig. 8 is a diagram for explaining the connection pattern 61 on the connecting coil 60. On the primary side, the terminals P12 and P13 are connected by the connection pattern 61a and the terminals P13 and P32 are connected by the connection pattern 61b. On the secondary side, the terminals P21 and P33 are connected by the connection pattern 61c. By doing so, the coils are connected in series on the primary side and the coils are connected in parallel on the secondary side as shown in Fig. 6. Concerning to the inner peripheral connecting hole 53, the terminals P31 and P32 which are connected to the primary coils N11 and N12 are provided at the region close to the terminals P11 through P13 on the primary side and the terminal P33 which is connected to the secondary coils N21 and N22 are provided at the region close to the terminals P21 through P23 on the secondary side. Because a gap d between the terminals P31 and P32 and the terminal P33 is equivalent to an insulation distance between the primary and the secondary, it is favorable to thus dispose the terminals separately on the primary side and the secondary side about the inner peripheral connecting hole 53 as the insulation distance increases.

Figs. 9A and 9B are drawings for explaining a distribution of NI in a direction of thickness of the coil laminate 50, wherein Fig. 9A shows a case when the primary coil P and secondary coil S are laminated and Fig. 9B shows a case when the secondary coils S are pinched by the primary coils P. Generally a leakage flux is proportional to a product NI of a current I within the coils and a number of coil windings N. Accordingly, because a distribution of leakage flux exits within the coils and the leakage flux becomes significant where the NI is large, AC resistance of the coil increases. When the primary coil P and the secondary coil S are laminated, NI becomes zero and a leakage flux also becomes zero at the most outer layer of the coil. Accordingly, when the connecting coil 60 is placed at the most outer layer, there is an effect that AC resistance in the connecting coil may be reduced. When the secondary coils S are pinched by the primary coils P, NI becomes zero at the center and the most outer layers. Then the effect that AC resistance in the connecting coil 60 may be reduced is brought about by providing the connecting coil 60 at the center layer or the most outer layer. It is favorable because a shield effect may be obtained electrostatically when the connecting coil 60 is provided on the most outer layer.

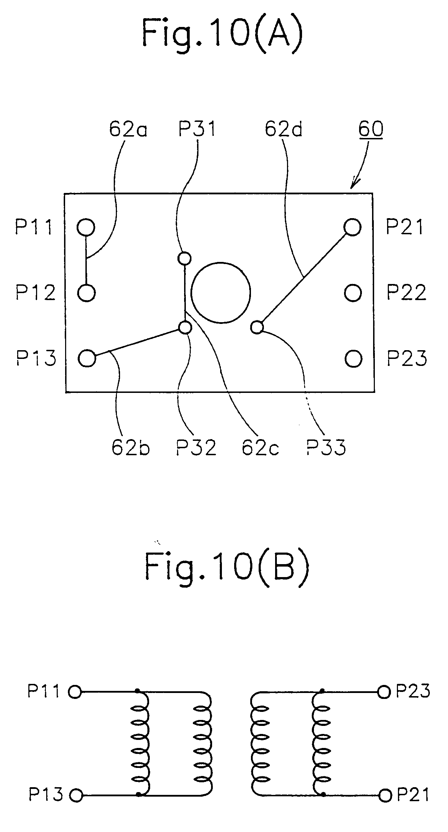

Figs. 10A and 10B are drawings for explaining another connection pattern 61 of the connecting coil 60, wherein Fig. 10A is a plan view of the connecting coil 60 and Fig. 10B is a connection diagram of the coil. On the primary side, the terminals P11 and P12 are connected by a connection pattern 62a, the terminals P13 and P32 are connected by a connection pattern 62b and the terminals P31 and 32 are connected by a connection pattern 62c. Further, on the secondary side, the terminals P21 and P33 are connected by a connection pattern 62d. Thereby, the coils are connected in parallel on the primary side and the coils are connected also in parallel on the secondary side. Thus various connection states may be selected even on the same coil laminate just by selecting a connection pattern of the connecting coil 60.

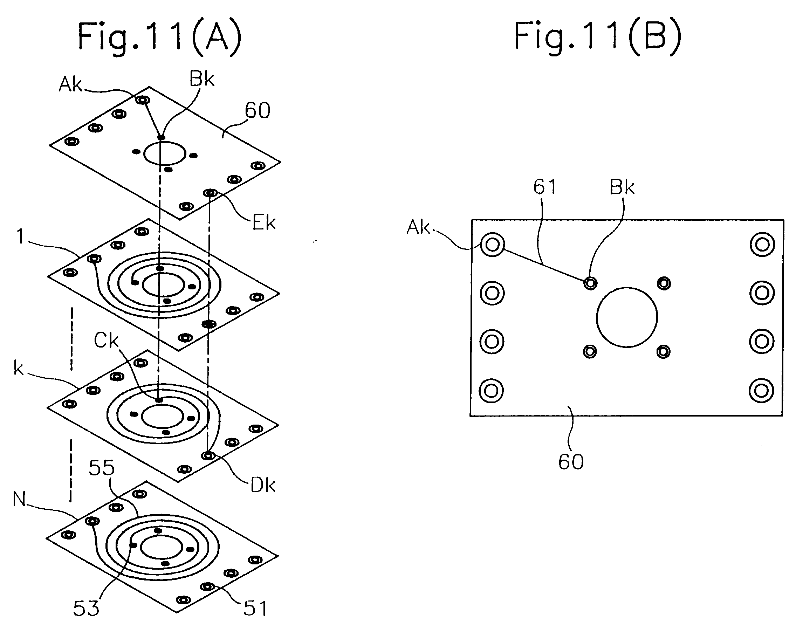

Figs. 11A and 11B are drawings for explaining a wiring state of the connecting coil 60 on the printed coil laminate 50, wherein Fig. 11A is a perspective view showing a lamination state and Fig. 11B is a top plan view of the connecting coil 60. The connecting coil 60 is placed as the top layer and under that, conductor forming planes 54 of the first layer, ... the k-th layer, ... the N-th layer are laminated. On the k-th layer conductor forming plane 54, a starting terminal Ck is provided at one of the inner peripheral connecting hole 53 and an ending terminal Dk is provided at one of the primary outer peripheral connecting hole 51 and a spiral conductor pattern 55 is connected between the starting terminal Ck and ending terminal Dk. Corresponding to that, on the connecting coil 60, a starting terminal Bk is provided at one of the inner peripheral connecting hole 53 corresponding to the starting terminal Ck and an ending terminal Ek is provided at one of the primary outer peripheral connecting hole 51 corresponding to the ending terminal Dk. Because the starting terminal Bk uses the inner peripheral connecting hole 53, it is inconvenient to connect with outside. Then one of the primary outer peripheral connecting hole 51 is allocated for a terminal Ak for connecting with outside and the terminal Ak for connecting with outside and the starting terminal Bk are connected by a radial connection pattern 61.

When there are N layers of the conductor forming planes 54, N starting terminals Bk are provided at the center portion of the connecting coil 60 and 2 N terminals of the terminals Ak and ending terminals Ck are provided in maximum at the peripheral portion. Because each of the conductor forming planes 54 is independent here, the peripheral terminal Dk may be provided at an arbitrary position and the peripheral terminal Ek may be provided at a position corresponding to that.

Connection between the coils such as serial, parallel and branch connections are made by the mutual connection among terminals Ai, Bj and Ek (i, j, k = 1, ... n). Because the terminals Ak, starting terminal Bk and peripheral terminal Ek which correspond to the starting terminal Ck and ending terminal Dk on each of the 54 are provided on the connecting coil 60, N conductor forming planes 54 may be connected from the starting terminal to the ending terminal at the arbitrary position, bringing about an effect that a degree of freedom of the coil connection is increased. Further, because a plurality of connection relationships of each conductor pattern may be realized on the same conductor forming plane 54 by appropriately selecting the connection pattern on the connecting coil 60, there is an effect that a mass-producibility is enhanced.

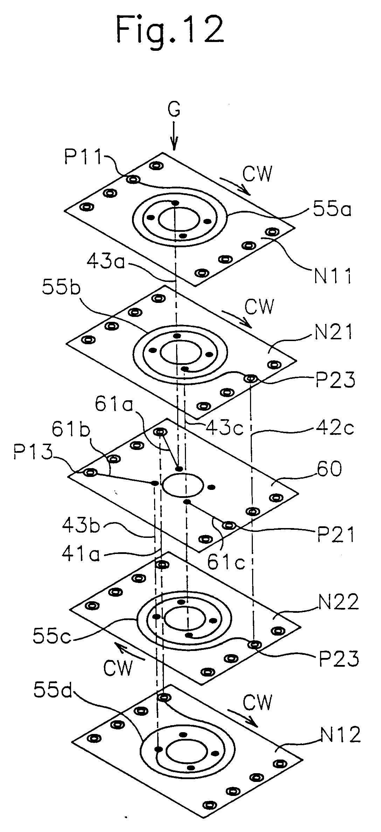

Fig. 12 is a drawing for explaining a connection state of the device in Fig. 7. In the figure, five layers of the printed coils are laminated in an order of a 11-th plane, 21st plane, connecting coil 60, 22nd plane and 12th plane. A primary coil n1 of the transformer is structured by two planes of the 11th plane whose outside terminal is the terminal P11 and the 12th plane having the conductor pattern 55d connected to the conductor pattern 55a on the 11th plane in series. Then the inside terminal of the conductor pattern 55a on the 11th plane and the inside terminal of the connection pattern 61a on the connecting coil 60 are connected by an inner peripheral terminal 43a, the outside terminal of the connection pattern 61a on the connecting coil 60 and the outside terminal of the conductor pattern 55d on the 12th plane are connected by a primary terminal 41a, the inside terminal of the conductor pattern 55d on the 12th plane and the inside terminal of the connection pattern 61d on the connecting coil 60 are connected by an inner peripheral terminal 43b and the outside terminal of the connection pattern 61d on the connecting coil 60 is used as the terminal P13.

A secondary coil n2 is structured by two planes of the 21st plane on which the outside terminal of the conductor pattern 55c is used as the terminal P23 and the 22nd plane on which the outside terminal of the conductor pattern 55c is used as the terminal P23. The conductor pattern 55b and the conductor pattern 55c are connected with the inside terminal of the connection pattern 61c on the connecting coil 60 by an inner peripheral terminal 43c. Then, because the outside terminal of the connection pattern 61c on the connecting coil 60 is used as the terminal P21, the conductor pattern 55b and the conductor pattern 55c are connected in parallel.

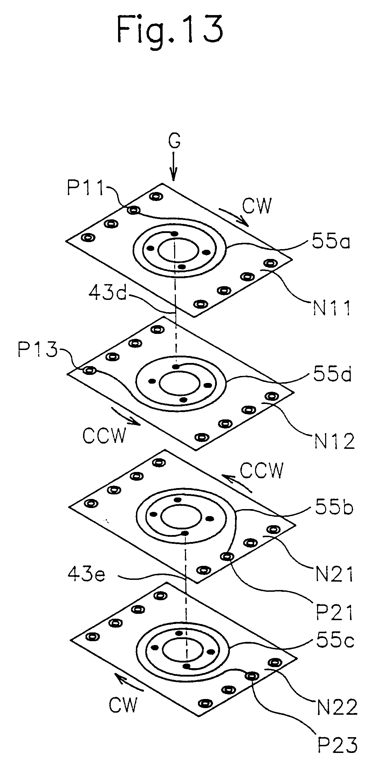

Fig. 13 is a drawing showing a structure of a prior art device for comparing with the embodiment shown in Fig. 12. Here, four layers of the printed coils are laminated in an order of the 11th plane, 12th plane, 21st plane and 22nd plane without using the connecting coil 60. A primary coil n1 of the transformer is structured by the 11th plane whose outside terminal is the terminal P11 and the 12th plane whose outside terminal is the terminal P13. The inside terminals of the conductor patterns 55a and 55d are connected by an inner peripheral terminal 43d. A secondary coil n2 is structured by two planes of the 21st plane whose outside terminal is the terminal P21 and the 22nd plane whose outside terminal is the terminal P23. The inside terminals of the conductor patterns 55b and 55c are connected by an inner peripheral terminal 43e. Accordingly, the conductor patterns 55a and 55d are connected in series as a primary winding n1 and the conductor patterns 55b and 55c are connected in series as a secondary winding n2.

Referring now to Figs. 12 and 13, an effect of the above described printed coil structure will be explained. At first, the enhancement of the magnetic coupling will be explained. The more the planes of the primary coil and secondary coil which directly contact, the better the magnetic coupling becomes. In the structure of the prior art shown in Fig. 13, the 12th and 21st planes are the subject of the magnetic coupling. Contrary to that, the 11th and 21st planes as well as the 12th and 22nd planes are the subject of the magnetic coupling. Because there is a characteristic that magnetic coupling is proportional to a square of coil area, the magnetic coupling is enhanced to four times.

Next, a reduction of loss will be explained. AC resistance increases when a current flows in the same direction with a parallel conductor and the increase of the AC resistance is suppressed when a current flows in the opposite direction (proximity effect). Because a current flows in the same direction on the 11th and 12th planes as well as the 21st and 22nd planes in the structure of the prior art shown in Fig. 13, their AC resistance increases. On the other hand, the direction of the current is opposite on the 11th and 21st planes and the 12th and 22nd planes, the AC resistance is suppressed. As a result, a coil loss may be reduced.

Next, a floating capacity will be explained. Gaps between the 11th and 12th planes, between the 12th and 21st planes and the 21st and 22nd planes become capacitors and cause a floating capacity in the prior art structure shown in Fig. 13. Normally, energy stored in a capacitor is proportional to a square of voltage and larger a potential between neighboring layers, greater the energy becomes. With a normal power source, a potential between the 11th and 12th planes is about 10 times of that between the 21st and 22nd planes. Accordingly, energy stored in the floating capacity of the 11th and 12th planes is dominant. Contrary to that, the gap between the 11th and 12th planes is separated in the embodiment shown in Fig. 12, stored energy between them is reduced to about 1/10. As a result, the floating capacity is reduced, improving high frequency characteristics of the transformer.

Finally, a point of coinciding winding directions will be explained. Generally, a direction of increase of voltage coincides with a coil winding direction. Accordingly, because a potential between coil layers becomes greater when winding directions of neighboring coils are opposite rather than when they are in the same direction and the energy stored in the floating capacity between the layers increases, the high frequency characteristics of the transformer degrades. In the prior art structure shown in Fig. 13, the winding directions of the conductor patterns are opposite on the 11th and 12th planes as well as on the 21st and 22nd planes. That is, the patterns are wound clockwise on the 11th and 21st planes and are wound counterclockwise on the 12th and 22nd planes. Here the counterclockwise refers to that when the conductor pattern is observed from a direction of arrow G, a shape of the spiral from the outside terminal Pij to the center is counterclockwise. Also the clockwise refers to that when the conductor pattern is observed from the direction of arrow G, the shape of the spiral from the outside terminal Pij to the center is clockwise.

Contrary to that, the winding direction of all the conductor patterns is unified clockwise except of the connecting coil 60 in the embodiment shown in Fig. 12. By constructing as described above, there are such effects that the energy stored in the floating capacity between the layers decreases, a substantial floating capacity drops and the high frequency characteristics of the transformer improves.

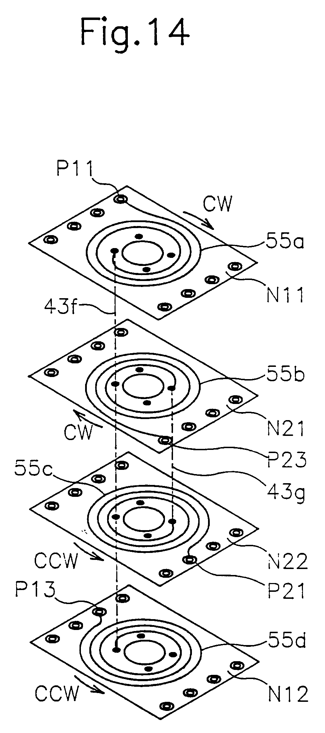

Fig. 14 is a perspective view showing another coil structure. A difference from the embodiment shown in Fig. 12 is that because no connecting coil 60 is used, a number of conductor patterns 55 may be provided on the conductor forming planes 54 even if the number of laminated printed coils is less. In the figure, four layers of the printed coils are laminated in an order of the 11th plane, 21st plane, 22nd plane and 21st plane. A primary coil n1 of the transformer is composed of the 11th plane whose outside terminal is the terminal P11 and the 12th plane whose outside terminal is the terminal P13. The conductor pattern 55a on the 11th plane is connected with the conductor pattern 55b on the 12th plane in series by an inner peripheral terminal 43f. A secondary coil n2 is composed of two planes of the 21th plane on which the outside terminal of the conductor pattern 55b is used as the terminal P21 and the 22th plane on which the outside terminal of the conductor pattern 55c is used as the terminal P23. The conductor pattern 55b is connected with the conductor pattern 55c in series by an inner peripheral terminal 43g. By the way, the winding direction of the conductor pattern is clockwise on the 11th and 21st planes and is counterclockwise on the 12th and 22nd planes.

In using the printed coil constructed as described above in the circuit shown in Fig. 6, the terminals P13 and P23 are connected to primary AC GND and secondary AC GND, respectively. Here, the AC GND refers to a ground on an AC equivalent circuit and the terminals are connected to the ground or to an electric conductor having a certain size and functions of the ground. Because the potential induced by the conductor pattern increases proportionally to a number of turns, AC potential increases from the outer periphery to the inner periphery between the 11th and 21st planes and AC potential increases from the outer periphery to the inner periphery between the 12th and 22nd planes. Accordingly, potential gradient in the radial direction becomes equal between the 11th and 21st planes and the 12th and 22nd planes, enabling to reduce the floating capacity. Because this capacity is a part of the floating capacity generated on the magnetic coupling plane of the primary and secondary windings described above, an effect that the high frequency insulating characteristic of the transformer is improved is brought about.

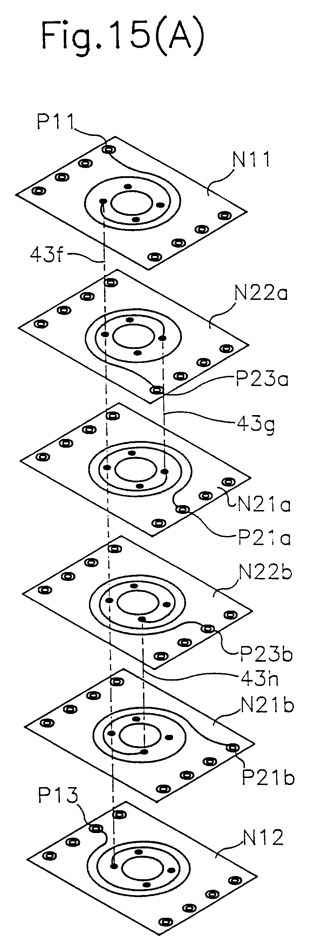

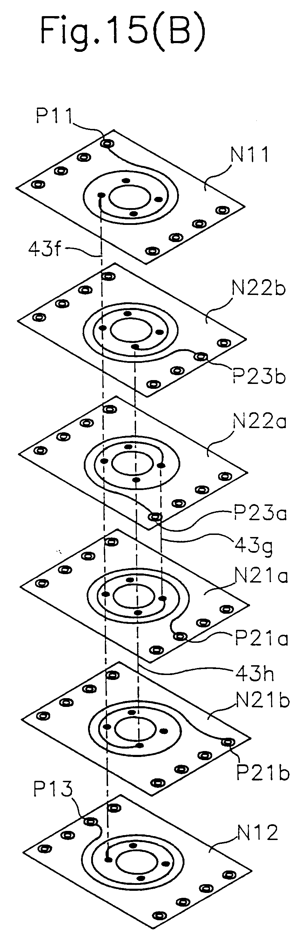

Figs. 15A and 15B are perspective views showing a coil structure wherein there are two secondary outputs. Fig. 15A shows a case when each of secondary windings are provided in parallel and Fig. 15B shows a case arranged telescopically. In the figures, each conductor pattern forming plane N2kx of the secondary winding is represented by outside terminals p2lx of the conductor pattern. Here (x) denotes an output number of the secondary winding which is (a) or (b) in this case. (k) represents a connection relationship of the terminals; k = 1 when the terminal is located on the AC ground side and k = 2 when it is located on the potential generating side. (l) represents a connection relationship of the outside terminals; l = 1 when k = 1 and l = 3 when k = 2.

In the case of Fig. 15A, conductor forming planes N22a and N21a of the first output of the secondary winding are laminated adjoining each other and are connected by the inner peripheral terminal 43g. Conductor forming planes N22b and N21b of the second output of the secondary winding are laminated adjoining each other and are connected by the inner peripheral terminal 43h. The conductor forming planes N22a through N21b of the secondary winding are pinched by conductor forming planes N11 and N12 of the primary winding. By doing so, such effects may be obtained that a leakage inductance reduces, the increase of the resistance due to the proximity effect may be suppressed and the floating capacity can be less as compare to the prior art example from the relationship of the magnetic coupling plane of the primary and secondary windings.

In the case of Fig. 15B, the conductor forming planes N22b and N22a having the terminals on the potential generating side of the secondary winding are laminated adjoining each other and the conductor forming planes N21a and N21b having the AC ground terminal of the secondary winding are laminated adjoining each other. The conductor forming planes N22b through N21b of the secondary winding are pinched by the conductor forming planes N11 and N12 of the primary winding. Accordingly, because the upper three layers and lower three layers are divided to be counterclockwise/clockwise respectively, the floating capacity may be even less as compare to those in Fig. 15A.

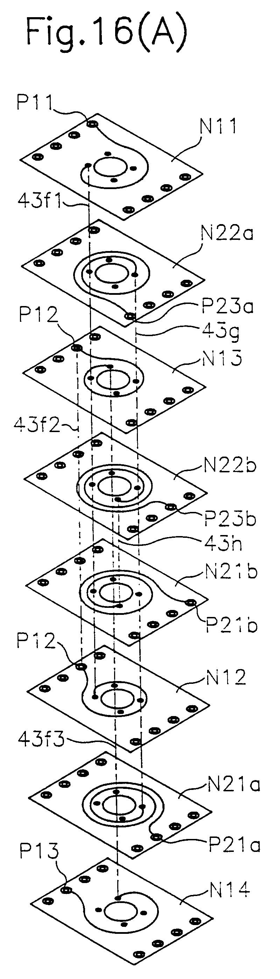

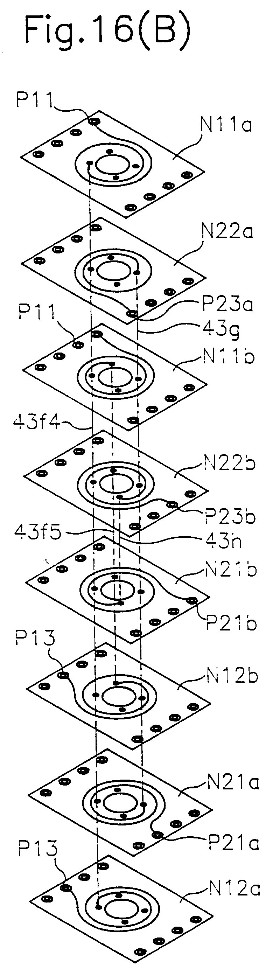

Figs. 16A and 16B are perspective views for explaining a case when a plurality of primary coils are provided, wherein Fig. 16A shows a case when four planes are connected in series to widen a width of the conductor pattern on each plane and Fig. 16B shows a case when sets of two planes are connected in parallel. In Fig. 16A, eight layers of conductor forming planes N11, N22a, N13, N22b, N21b, N12, N21a and N14 are assembled and the upper four layers and lower four layers are divided to be counterclockwise/clockwise, respectively. As the primary winding, they are laminated in an order of N11, N13, N12 and N14. The conductor forming planes N11 and N12 are connected by an inner peripheral terminal 43f1, the conductor forming planes N12 and N13 are connected by an inner peripheral terminal 43f2 and the conductor forming planes N13 and N14 are connected by an inner peripheral terminal 43f2. Thus the conductor forming planes are connected in series in an order of N11, N12, N13 and N14. An AC voltage generated on the primary winding is the highest on the conductor forming plane N14 and is the lowest on the conductor forming plane N11.

The conductor forming planes N22a and N21a of the first output of the secondary winding are laminated while being separated as the second layer and seventh layer from the top and are connected by the inner peripheral terminal 43g. The conductor forming planes N22b and N21b of the second output of the secondary winding are laminated adjoining each other and are connected by the inner peripheral terminal 43h. Here the current capacity is increased by reducing the number of windings per one conductor forming plane into half and by doubling the width of the conductor pattern as compare to the case of Fig. 15B. A middle primary winding pinches the conductor forming planes N22b and N21b which are the second output circuit of the secondary winding by the conductor forming planes N12 and N13. And the middle primary winding is pinched by the conductor forming planes N22a and N21a which are the first output circuit of the secondary winding. The most outer layers are covered by the conductor forming planes N11 and N14 of the primary winding which are connected with the outside.

In the case of Fig. 16B, the first input circuits of the conductor forming planes N11a and N12a which become the primary winding are laminated while being separated as the first and eighth layer from the top and are connected by an inner peripheral terminal 43f4. The second input circuits of the conductor forming planes N11b and N12b are laminated adjoining each other as the fourth and fifth layers and are connected by an inner peripheral terminal 43f5. The first and second input circuits are connected in parallel by the terminals P11 and P13. By the way, the conductor forming planes N22a and N21a of the first output of the secondary winding are laminated while being separated as the second and seventh layers from the top and are connected by the inner peripheral terminal 43g. Further, the conductor forming planes N22b and N21b of the second output of the secondary winding are laminated adjoining each other and are connected by the inner peripheral terminal 43h. This configuration allows to increase the current capacity even if the number of winding of the conductor pattern for primary winding and the width of the conductor pattern are the same with those in Fig. 15.

As described above, the secondary coil 20 is pinched by the primary coil 10 and the primary winding and secondary winding of the transformer are formed by connecting the interlayer link lines provided at the middle of the conductor forming planes, so that such effects can be obtained that the leakage inductance reduces, the increase of resistance due to the proximity effect may be suppressed and the floating capacity can be less as compare to the prior art example from the relationship of the magnetic coupling planes of the primary and secondary windings.

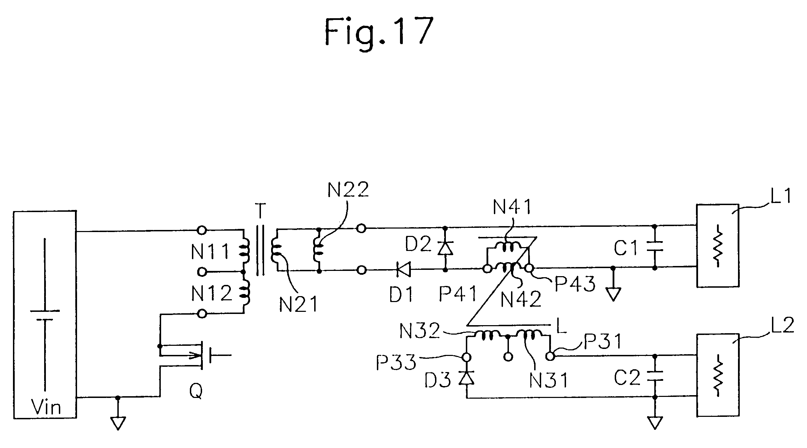

Fig. 17 is a circuit diagram showing a choking coil. Similarly to Fig. 6, DC power source Vin is applied to the primary winding and the switching element Q turns ON/OFF. Then a switching signal is induced on the secondary winding and is sent to an output circuit comprising diodes D1 and D2, main winding of a choking coil L and capacitor C1 and a rectified and smoothed DC voltage is supplied to a main load L1. A rectifying and smoothing circuit comprising a diode D3 and capacitor C2 is connected on the auxiliary winding side of the choking coil L to supply DC power to an auxiliary load L2.

In this example, primary coils N31 and N32 are connected in series on the auxiliary winding side of the choking coil L and secondary coils N41 and N42 are connected in parallel on the main winding side. Further, a terminal P31 is connected with one end of the capacitor C2 and a terminal P33 is connected with the capacitor C2 via the diode D3. Further, terminals P41 and P43 connect the diode D1 and capacitor C1.

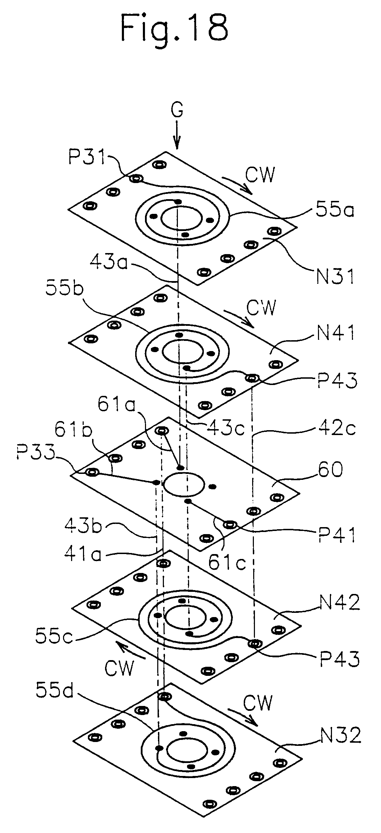

Fig. 18 is a perspective view for explaining a connection state of the choking coil used in Fig. 17. Basically, although a lamination state of the printed coils in Fig. 18 is substantially the same with that shown in Fig. 12, reference numerals of the conductor forming planes and terminals are matched with those in Fig. 17 in order to conform to Fig. 17. Five layers of printed coils are laminated in an order of 31st plane, 41st plane, connecting coil 60, 42nd plane and 32nd plane. The auxiliary winding of the choking coil L is structured by two planes of the 31st plane whose outside terminal is the terminal P31 and the 32th plane having the conductor pattern 55d connected to the conductor pattern 55a on the 31th plane in series. Then the inside terminal of the conductor pattern 55a on the 31th plane and the inside terminal of the connection pattern 61a on the connecting coil 60 are connected by an inner peripheral terminal 43a, the outside terminal of the connection pattern 61a on the connecting coil 60 and the outside terminal of the conductor pattern 55d on the 32th plane are connected by a primary terminal 41a, the inside terminal of the conductor pattern 55d on the 32th plane and the inside terminal of the connection pattern 61d on the connecting coil 60 are connected by an inner peripheral terminal 43b and the outside terminal of the connection pattern 61d on the connecting coil 60 is used as the terminal P33.

The main winding of the choking coil L is structured by two planes of the primary terminal 41st plane on which the outside terminal of the conductor pattern 55c is used as the terminal P43 and the secondary terminal 42nd plane on which the outside terminal of the conductor pattern 55c is used as the terminal P43. The conductor pattern 55b and the conductor pattern 55c are connected with the inside terminal of the connection pattern 61c on the connecting coil 60 by an inner peripheral terminal 43c. Then, because the outside terminal of the connection pattern 61c on the connecting coil 60 is used as the terminal P41, the conductor pattern 55b and the conductor pattern 55c are connected in parallel.

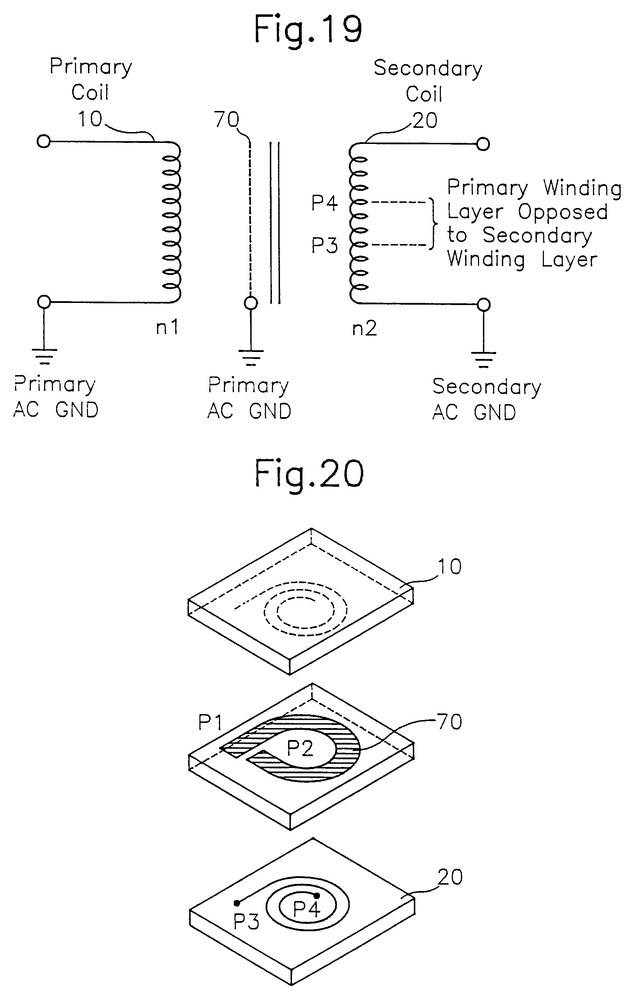

Now a first embodiment of the present invention will be explained. Some transformer has a shield such as one disclosed in Japanese Utility Model Laid-open No. 62-201915 which the applicant of the present invention proposed. Fig. 19 is a circuit diagram of such a transformer. In the figure, AC current is applied to one end of the anode of a primary winding n1 of the transformer and the other end thereof is grounded to a primary ground AC GND. Further, one end of a secondary winding n2 is grounded to a secondary ground AC GND and AC current is induced on the other end thereof. A ground shield winding is attached between the primary winding and the secondary winding and one end thereof is grounded to the primary AC GND.

Fig. 20 is a perspective view of a structure of main part of a printed coil type transformer showing a packaged state equivalent to the circuit in Fig. 19. A conductor pattern equivalent to the primary winding n1 is formed on the base of the primary coil 10. A secondary coil 20, which is a conductor pattern equivalent to the secondary winding n2, is formed on the base thereof, wherein several turns of a spiral conductor pattern from a starting terminal P3 to ending terminal P4 is formed on one plane in this example. Then the shield coil 70 is inserted between the bases of the primary coil 10 and the secondary coil 20 where they oppose to each other. The shield coil 70 has one turn of spiral wide conductor pattern from a starting terminal P1 to an ending terminal P2 formed on one plane.

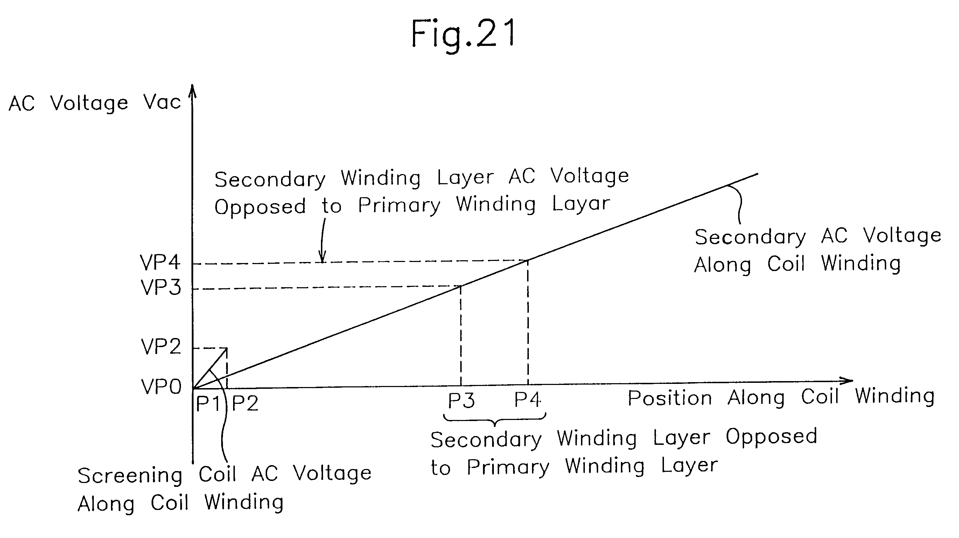

Fig. 21 is a graph showing a relationship between a number of windings of each winding and AC voltage. AC voltage Vac induced corresponding to position along coil winding increases on the secondary coil 20. Assuming here that a voltage of secondary winding layer opposed to the primary winding layer is Vp3 at the starting terminal P3 and is Vp4 at the ending terminal P4, then the voltage of the secondary winding layer opposed to the primary winding layer is between Vp3 to Vp4. By the way, the winding layer opposed to the primary winding layer is the shield coil 70 or the layer on which the conductor pattern opposed to the 1 is formed. By the same token, because the winding layer is formed only on one plane in the shield coil 70, the shield voltage thereof is in the range of Vp1 to Vp2.

However, there has been a problem that a noise current flows degrading the characteristics as a transformer when the potential difference between the AC voltage of the secondary winding layer opposed to the primary winding layer (Vp3 to Vp4) and the voltage of the shield coil (Vp1 to Vp2) is large and that a separate noise filtering circuit having a good noise reducing characteristic is necessary to use for a switching power source for example. The first embodiment solves this problem and provides a printed coil type transformer having a good shielding characteristic.

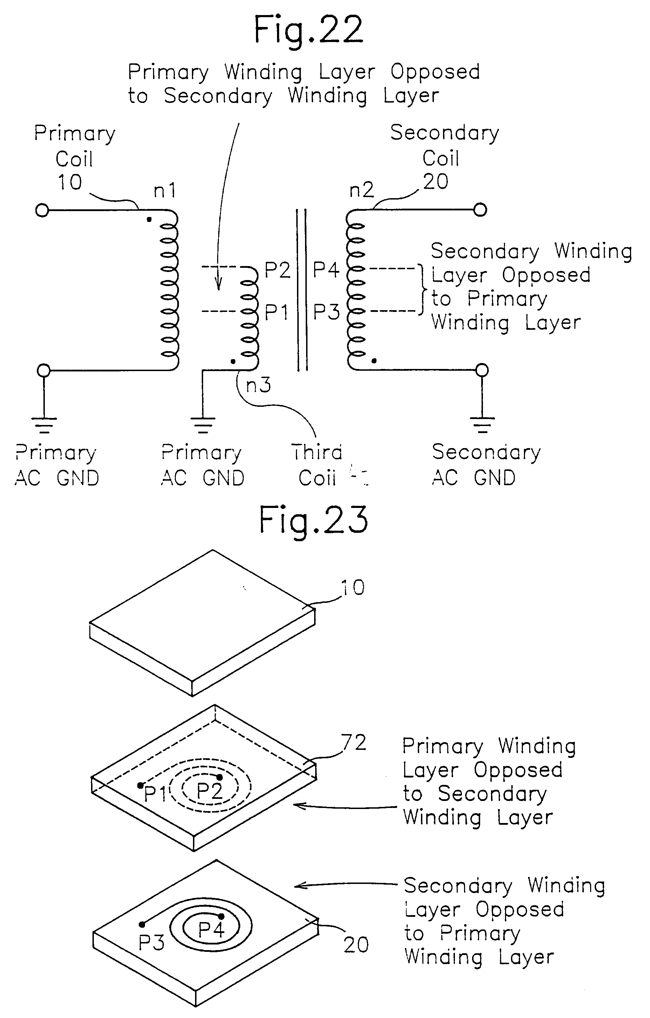

Fig. 22 is a circuit diagram showing the first embodiment of the present invention. In the figure, the primary winding n1 is a conductor pattern wound so that a polarity of the transformer becomes opposite from that of the secondary winding n2. A third winding n3 is grounded to the AC GND common with the AC GND of the primary winding and its conductor pattern is formed so that its polarity coincides with the secondary winding.

Fig. 23 is a perspective view of a main part of the device in Fig. 22 showing a packaged state thereof. The secondary coil 22 is the conductor pattern which is equivalent to the secondary winding n2 formed on the base thereof, wherein several turns of a spiral conductor pattern from a starting terminal P3 to ending terminal P4 are formed on one plane of the conductor winding layer closest to the primary coil 10. The third coil 72 is inserted between the bases of the primary coil 10 and the secondary coil 20 where they oppose to each other and a spiral conductor pattern from a starting terminal P1 to an ending terminal P2 is formed on a plane opposed to the secondary coil 20. The primary coil 10 is mounted on the third coil 72.

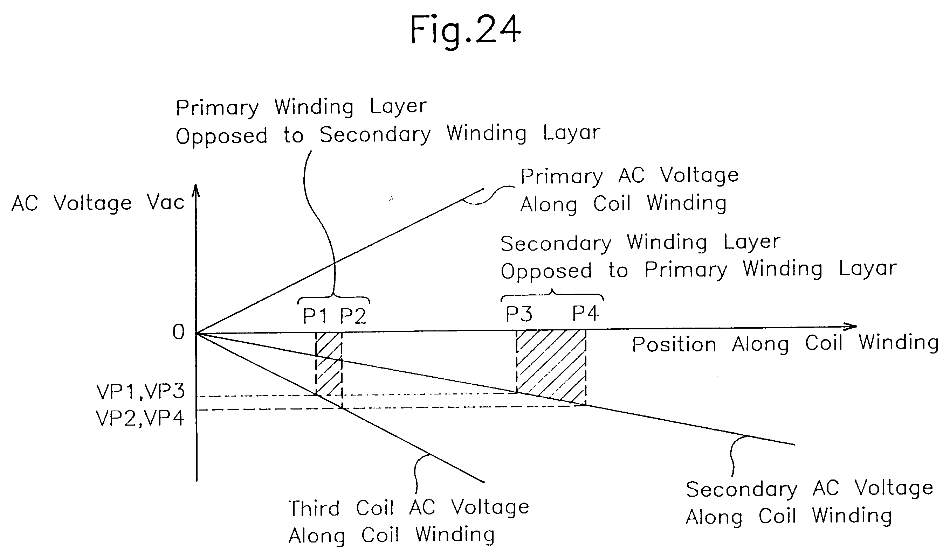

Fig. 24 is a graph showing a relationship between a number of windings of each winding and AC voltage. AC voltage Vac induced corresponding to position along coil winding increases on the secondary coil 20. Assuming that a voltage of secondary winding layer opposed to the third coil 72 is Vp3 at the starting terminal P3 and is Vp4 at the ending terminal P4, then, the voltage of the secondary winding layer opposed to the primary winding layer is in the range of Vp3 to Vp4. For the third coil 72, the voltage of the primary winding layer opposed to the secondary winding layer Vp1 to Vp2 is predetermined to coincide with the voltage of the secondary winding layer opposed to the primary winding coil Vp3 to Vp4. On the other hand, because the winding direction of the primary coil 10 is opposite, generated AC voltage is an opposite voltage from that of the secondary coil 20 and no region which coincides with the secondary winding layer opposed to the primary winding layer Vp3 to Vp4 exists.

Now the point of forming the conductor pattern so that the voltage of the primary winding layer opposed to the secondary winding layer Vp1 to Vp2 coincides with the secondary winding layer opposed to the primary winding layer Vp3 to Vp4 will be explained. Assuming that the shape of this conductor pattern has a mirror image relationship with that formed on the layer opposed to the primary winding layer of the secondary coil 20, the voltages induced by the AC current applied to the primary winding coincide from the electromagnetic knowledge concerning on windings. By the way, it is not favorable because the separation becomes considerably small in the distribution in the radial direction even if the directions of the spirals are opposite. Further, because almost no current flows in the third coil 72, the pattern width of the conductor patterns other than that of the primary winding layer opposed to the secondary winding layer may be narrowed down and one layer will do.

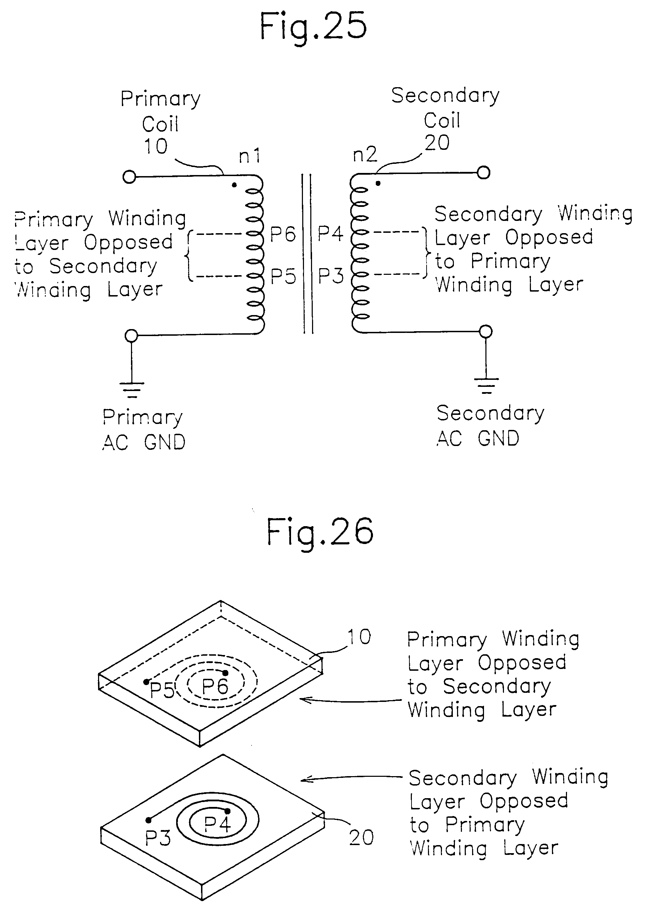

Fig. 25 is a circuit diagram showing a second embodiment of the present invention. A difference from Fig. 22 is that the primary winding n1 is a conductor pattern wound so that the transformer polarity coincides with that of the secondary winding n2.

Fig. 26 is a perspective view of a main part of the device in Fig. 25 showing a packaged state thereof. The secondary coil 20 is a conductor pattern which is equivalent to the secondary winding n2 formed on the base thereof, wherein several turns of a spiral conductor pattern from a starting terminal P3 to ending terminal P4 are formed on one plane. The primary coil 10 is a conductor pattern which is equivalent to the secondary winding n1 formed on the base thereof, wherein several turns of a spiral conductor pattern from a starting terminal P5 to ending terminal P6 are formed on the plane opposed to the secondary coil 20.

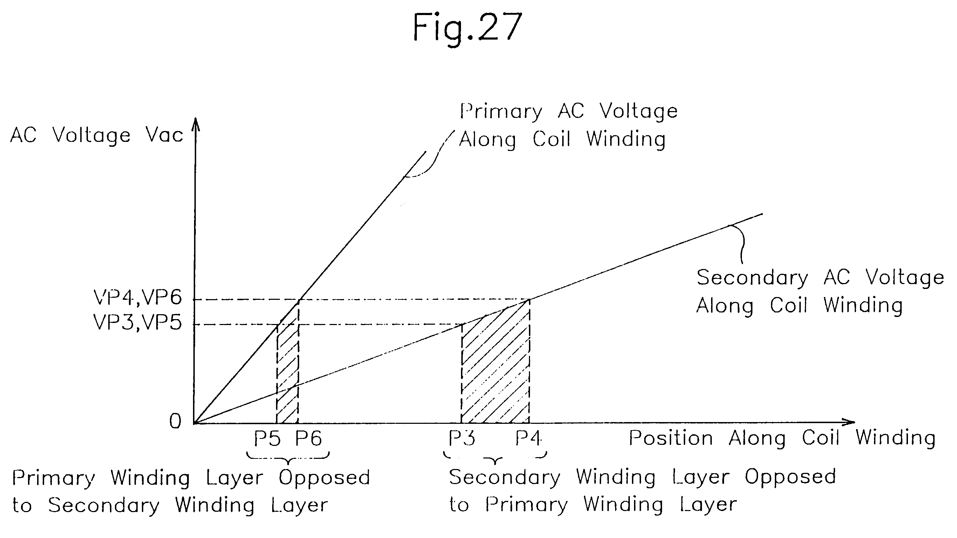

Fig. 27 is a graph showing a relationship between a number of windings of each winding and AC voltage. AC voltage Vac induced corresponding to position along coil winding increases on the secondary coil 20. Assuming that a voltage of secondary winding layer opposed to the primary coil 10 is Vp3 at the starting terminal P3 and is Vp4 at the ending terminal P4, voltage of the secondary winding layer opposed to the primary winding layer is in the range between Vp3 to Vp4. For the primary coil 10, the voltage (Vp5 to Vp6) of the primary winding layer opposed to the secondary winding layer is predetermined to coincide with the voltage (Vp3 to Vp4) of the secondary winding layer opposed to the primary winding coil. Preferably, if the shape of the conductor pattern formed on the layer of the secondary coil 20 opposed to the primary winding layer and the conductor pattern formed on the layer of the primary coil 10 opposed to the secondary winding layer has a mirror-image relationship, the voltages induced on the secondary winding by the AC voltage applied to the primary winding coincide at the opposed layers.

By the way, although only one conductor pattern layer of the primary coil 10 and the secondary coil 20 are shown as a packaging mode of transformer in the aforementioned embodiments, there are actually stacked by several layers respectively because the winding ratio needs to be determined corresponding to a converting voltage ratio of a DC-DC converter used.

As described above, the third coil 70 is inserted between the primary coil 10 and the secondary coil 20 and is grounded on the primary side and voltage of the conductor pattern of the third coil is predetermined to coincide with voltage induced on the conductor pattern of the secondary coil 20, so that such an effect may be obtained that no noise current caused by AC potential difference flows and a high shielding effect can be obtained.

While preferred embodiments have been described, variations thereto will occur to those skilled in the art within the scope of the present inventive concepts which are delineated by the following claims.

## Claims

1. Printed coil type transformer, including:
a primary coil means (10) comprising a conductor pattern equivalent to a primary winding (n1) of a transformer;
a secondary coil means (20) comprising a conductor pattern equivalent to a secondary winding (n2) of said transformer;
said primary winding and said secondary winding being connected to independent grounds, and wherein transformer polarity of said primary winding and said secondary winding being opposite; and
a third coil means (72) comprising a conductor pattern, one end of which is grounded and whose transformer polarity coincides with that of said secondary winding;
wherein said third coil means (72) further comprises a conductor winding layer on which voltage of said conductor pattern on said third coil means (72) generated by an AC voltage applied to said primary winding almost coincides with a voltage generated on said secondary winding.

2. Printed coil type transformer, including
a primary coil means (10) comprising a conductor pattern equivalent to the primary winding (n1) of a transformer, and
a secondary coil means (20) comprising a conductor pattern equivalent to the secondary winding (n2) of said transformer;
said primary and secondary windings being grounded at respective independent AC grounds (AC GND) and their conductor patterns are identical in transformer polarity;
said secondary and primary coils being laminated such that the voltage across said secondary coil conductor pattern layer on the plane opposite to said primary coil is nearly equal to the voltage across said primary coil conductor pattern layer on the plane opposite to said secondary coil.

3. The printed coil type transformer of claim 2, wherein said secondary coil conductor pattern on the plane opposite to said primary coil is the mirror image of said primary coil conductor pattern on the plane opposite to said secondary coil.
